# EUROPEAN PATENT APPLICATION

(11) **EP 4 838 239 A1**
(43) Date of publication of application: **11.11.2026**
(21) Application number: 24921165.7
(22) Date of filing: 03.04.2024
(51) Int. Cl.: G01R 31/378, G01R 31/387, G01R 31/388

(54) **METHOD FOR EVALUATING EFFECTIVE REPLENISHMENT LEVEL OF ACTIVE IONS IN SECONDARY ION BATTERY**

(30) Priority: 01.02.2024 CN 202410142206
(71) Applicant: Contemporary Amperex Technology Co., Limited, Ningde, Fujian 352100 (CN)
(72) Inventor: LI, Maohua, Ningde, Fujian 352100 (CN); MIAO, Xinghui, Ningde, Fujian 352100 (CN); CHEN, Xiao, Ningde, Fujian 352100 (CN); XIE, Haotian, Ningde, Fujian 352100 (CN); ZHANG, Nannan, Ningde, Fujian 352100 (CN); GENG, Huihui, Ningde, Fujian 352100 (CN); YANG, Longfei, Ningde, Fujian 352100 (CN)
(74) Representative: Lorenz Seidler Gossel Part. mbB
(86) International application number: PCT/CN2024/085888
(87) International publication number: WO 2025/161121

(57) **Abstract**

A method for evaluating the effective replenishment level of active ions in a secondary ion battery, the secondary ion battery being a first battery, and a corresponding secondary ion battery without replenished active ions being a second battery, and the method comprising: obtaining a discharge capacity C₂ of the first battery within a nominal voltage range; charging the first battery and the second battery to respective preset voltages U, such that anode potentials of the first and second batteries are equal at the preset voltages U, and calculating a charging capacity difference C₁ between the first battery and the second battery at the time; and calculating the sum C₃ of the charging capacity difference C₁ and the discharge capacity C₂, where C₃ is used to represent the total effective capacity of active ions in the first battery.

## Description

### CROSS-REFERENCE TO RELATED APPLICATIONS

This application claims priority to the Chinese Patent Application No. 202410142206.1, filed on February 1, 2024 and entitled "EVALUATION METHOD FOR EFFECTIVE REPLENISHMENT LEVEL OF ACTIVE IONS IN SECONDARY ION BATTERY", which is incorporated herein by reference in its entirety.

### TECHNICAL FIELD

This application relates to the field of battery technology, and in particular, to an evaluation method for an effective replenishment level of active ions in a secondary ion battery.

### BACKGROUND

In a secondary ion battery, during a first-cycle lithium intercalation process of an anode electrode active material, an electrolyte undergoes a reduction reaction on the particle surface to form a solid electrolyte interface (SEI) film, which consumes cathode active ions (such as active lithium or active sodium), thus affecting the gram capacity utilization of a cathode electrode active material, and reducing the energy density of the battery.

An electrode material is subjected to lithium replenishment or sodium replenishment through pre-lithiation technology or pre-sodiation technology, so that active lithium or active sodium released during the charging process compensates for the first-cycle irreversible lithium or irreversible sodium loss to form the SEI film on an anode surface, thereby improving the reversible cycling capacity and cycle life of the secondary ion battery. The anode, cathode, separator, electrolyte, and current collector of the secondary ion battery can all achieve the purpose of optimizing battery performance through lithium replenishment or sodium replenishment technology.

Although lithium replenishment or sodium replenishment can improve the energy density and cycling performance of the battery, a larger amount of lithium replenishment or sodium replenishment does not always yield better results, and excess or insufficient lithium replenishment or sodium replenishment affects the battery performance. Therefore, how to accurately evaluate an effective replenishment amount and replenishment efficiency of active ions is crucial for pre-lithiation technology or pre-sodiation technology.

### SUMMARY

This application provides an evaluation method for an effective replenishment level of active ions in a secondary ion battery to more accurately evaluate the effective replenishment effect of active ions.

This application provides an evaluation method for an effective replenishment level of active ions in a secondary ion battery, where the secondary ion battery is a first battery, and a secondary ion battery without active ion replenishment corresponding to the secondary ion battery is a second battery. The evaluation method includes: acquiring a discharge capacity C₂ of the first battery during discharging in a nominal voltage range; charging the first battery and the second battery to respective preset voltages U, and when an anode potential of the first battery is equal to an anode potential of the second battery at the preset voltages U, calculating a charge capacity difference C₁ of the first battery and the second battery at this point; and calculating a sum C₃ of the charge capacity difference C₁ and the discharge capacity C₂, where C₃ is used to characterize a total effective capacity of active ions in the first battery.

In any embodiment, the evaluation method includes: acquiring curves, including: acquiring a first curve and a second curve of the first battery and the second battery during a charging process or a discharging process in a nominal voltage range, and the discharge capacity C₂ of the first battery, where both the first curve and the second curve are full charging process curves or full discharging process curves, the first curve is an anode potential-battery voltage curve of the first battery, and the second curve is an anode potential-battery voltage curve of the second battery; acquiring a voltage range U₁, including: determining a battery voltage range U₁₋₁ of the first battery and a battery voltage range U₂₋₁ of the second battery corresponding to portions having identical curve shapes in an identical anode potential range in the first curve and the second curve; acquiring a capacity difference C₁, including: acquiring charge capacities of the first battery and the second battery when the first battery and the second battery are charged to the respective preset voltages U, where the preset voltage U of the first battery is any value in U₁₋₁, and the preset voltage U of the second battery is any value in U₂₋₁; and calculating the charge capacity difference C₁ of the first battery and the second battery at this point; and acquiring a total effective capacity of active ions, including: calculating a sum C₃ of the charge capacity difference C₁ and the discharge capacity C₂.

In any embodiment, the process of acquiring the capacity difference C₁ includes: discharging the first battery and the second battery respectively and then charging the first battery and the second battery to the respective preset voltages U, and calculating the charge capacity difference C₁ of the first battery and the second battery at this point, where the first battery is discharged to a nominal lower-limit voltage, and the second battery is discharged to an anode potential of 1 V to 2.5 V or discharged until the anode potential reaches an SEI film decomposition potential.

In any embodiment, a discharge rate is any rate selected from 0.02C to 0.1C.

In any embodiment, the first battery and the second battery are charged respectively to the preset voltages U at any rate ranging from 0.02C to 0.1C.

In any embodiment, the preset voltage U of the first battery is a median voltage value of U₁₋₁, and the preset voltage U of the second battery is a median voltage value of U₂₋₁.

In any embodiment, the process of determining U₁₋₁ and U₂₋₁ includes: shifting a voltage value t₁ of the first curve and/or shifting a voltage value t₂ of the second curve along a coordinate line where a battery voltage is located, so that the first curve and the second curve overlap in a battery voltage range U', where t₁ and t₂ are negative values when the shift is performed in a direction toward a lower battery voltage, t₁ and t₂ are positive values when the shift is performed in a direction toward a higher battery voltage, and optionally, t₁ and t₂ satisfy any one or more of the following conditions: 0 V≤|t₁|≤2.0 V, 0 V≤|t₂|≤2.0 V, and 0 V≤|t₁|+|t₂|≤2.0 V; and calculating U₁₋₁ and U₂₋₁ according to the following formulas: U₁₋₁=U'-t₁, and U₂₋₁=U'-t₂.

In any embodiment, the process of acquiring the curves further includes a process of acquiring a third curve and a fourth curve during a charging process or a discharging process in a nominal voltage range, where both the third curve and the fourth curve are full charging process curves or full discharging process curves, the third curve is an SOC-battery voltage curve of the first battery, and the fourth curve is an SOC-battery voltage curve of the second battery; and the evaluation method further includes: determining a first battery voltage range U₁₋₂ corresponding to a curve segment in the third curve where a slope does not exceed 400% SOC/battery voltage, and determining a second battery voltage range U₂₋₂ corresponding to a curve segment in the fourth curve where a slope does not exceed 400% SOC/battery voltage; determining a voltage range U₁ where U₁₋₁ and U₁₋₂ overlap; and determining a voltage range U₂ where U₂₋₁ and U₂₋₂ overlap; where in the process of acquiring the charge capacity difference C1, the preset voltage U of the first battery is any value in U₁, and the preset voltage U of the second battery is any value in U₂.

In any embodiment, the preset voltage U of the first battery is a median voltage value of U₁, and the preset voltage U of the second battery is a median voltage value of U₂.

In any embodiment, the process of acquiring the curves includes: performing charging treatment or discharging treatment on the first battery and the second battery respectively at an identical rate in the nominal voltage range to acquire the first curve and the second curve.

In any embodiment, a rate of the charging process or the discharging process is any rate selected from 0.02C to 0.1C.

In any embodiment, the evaluation method further includes a step of recording a discharge capacity C₄ of the second battery; and the evaluation method further includes a process of calculating active ion replenishment efficiency, where the active ion replenishment efficiency is denoted as A=(C₃-C₄)/C₅, and C₅ is a theoretical active ion replenishment capacity.

In any embodiment, a reference electrode is a conductive wire with an active material layer on a surface, a diameter of the conductive wire is 50 µm to 100 µm, and a thickness of the active material layer is 10 µm to 50 µm.

In any embodiment, the reference electrode is a copper wire, a copper wire with a lithium-plated layer on a surface, a copper wire with a sodium-plated layer on a surface, a copper wire coated with a lithium iron phosphate layer on a surface, a copper wire coated with a lithium titanate layer on a surface, or a copper wire coated with a sodium vanadium phosphate layer on a surface.

In any embodiment, when the reference electrode is a copper wire, before evaluation is performed, a positive electrode of the first battery is used as a positive electrode, the copper wire is used as a negative electrode, and charging is performed for 1 h at a constant current of 10 µA to perform electroplating treatment on the copper wire of the first battery; and a positive electrode of the second battery is used as a positive electrode, the copper wire is used as a negative electrode, and charging is performed for 1 h at a constant current of 10 µA to perform electroplating treatment on the copper wire of the second battery.

In any embodiment, when the reference electrode is a copper wire coated with a lithium iron phosphate layer on a surface, a copper wire coated with a lithium titanate layer on a surface, or a copper wire coated with a sodium vanadium phosphate layer on a surface, the evaluation method further includes a process of first activating the reference electrode, where the process of activating the reference electrode includes: charging the first battery and the second battery respectively to a battery voltage corresponding to 50±5% SOC.

In any embodiment, both the first battery and the second battery are full cells, and the secondary ion battery is a lithium-ion secondary battery or a sodium-ion secondary battery.

In any embodiment, the evaluation method includes:
providing a reference electrode in each of the first battery and the second battery, and using the reference electrodes to monitor anode potentials of the first battery and the second battery during charging and discharging processes, where both the first battery and the second battery are full cells, the reference electrode is a copper wire, a copper wire with lithium plated on a surface, a copper wire with sodium plated on a surface, a copper wire coated with lithium iron phosphate on a surface, a copper wire coated with lithium titanate on a surface, or a copper wire coated with sodium vanadium phosphate on a surface, a diameter of the copper wire is 50 µm to 100 µm, and a thickness of an active material layer on the copper wire is 10 µm to 50 µm; when the reference electrode is a copper wire, before performing evaluation, using a positive electrode of the first battery as a positive electrode and the copper wire as a negative electrode to perform charging for 1 h at a constant current of 10 µA so as to perform electroplating treatment on the copper wire of the first battery, and using a positive electrode of the second battery as a positive electrode and the copper wire as a negative electrode to perform charging for 1 h at a constant current of 10 µA so as to perform electroplating treatment on the copper wire of the second battery; and when the reference electrode is a copper wire coated with lithium iron phosphate on a surface, a copper wire coated with lithium titanate on a surface, or a copper wire coated with sodium vanadium phosphate on a surface, charging the first battery and the second battery respectively to a battery voltage corresponding to 50±5% SOC so as to activate the reference electrode;
charging the first battery and the second battery in a nominal voltage range at any rate ranging from 0.02C to 0.1C, acquiring an anode potential-battery voltage curve and an SOC-battery voltage curve of the first battery, and an anode potential-battery voltage curve and an SOC-battery voltage curve of the second battery, defining the anode potential-battery voltage curve of the first battery as a first curve, defining the anode potential-battery voltage curve of the second battery as a second curve, defining the SOC-battery voltage curve of the first battery as a third curve, and defining the SOC-battery voltage curve of the second battery as a fourth curve;
determining a battery voltage range U₁₋₁ of the first battery and a battery voltage range U₂₋₁ of the second battery corresponding to portions having identical curve shapes in an identical anode potential range in the first curve and the second curve, where the process of determining U₁₋₁ and U₂₋₁ includes: shifting a voltage value t₁ of the first curve and/or shifting a voltage value t₂ of the second curve along a coordinate line where a battery voltage is located, so that the first curve and the second curve overlap in a battery voltage range U', where t₁ and t₂ are negative values when the shift is performed in a direction toward a lower battery voltage, t₁ and t₂ are positive values when the shift is performed in a direction toward a higher battery voltage, and optionally, t₁ and t₂ satisfy any one or more of the following conditions: 0 V≤|t₁|≤2.0 V, 0 V≤|t₂|≤2.0 V, and 0 V≤|t₁|+|t₂|≤2.0 V; and calculating U₁₋₁ and U₂₋₁ according to the following formulas: U₁₋₁=U'-t₁, and U₂₋₁=U'-t₂;
determining a first battery voltage range U₁₋₂ corresponding to a curve segment in the third curve where a slope does not exceed 400% SOC/battery voltage, and determining a second battery voltage range U₂₋₂ corresponding to a curve segment in the fourth curve where a slope does not exceed 400% SOC/battery voltage;
determining a voltage range U₁ where U₁₋₁ and U₁₋₂ overlap, and determining a voltage range U₂ where U₂₋₁ and U₂₋₂ overlap;
discharging the first battery and the second battery, where a discharge rate is any rate selected from 0.02C to 0.1C, the first battery is discharged to a nominal lower-limit voltage, and the second battery is discharged to an anode potential of 1 V to 2.5 V or discharged until the anode potential reaches an SEI film decomposition potential; recording a discharge capacity C₂ of the first battery and a discharge capacity C₄ of the second battery; acquiring charge capacities of the first battery and the second battery when the first battery and the second battery are charged respectively to the preset voltages U at any rate ranging from 0.02C to 0.1C, where the preset voltage U of the first battery is a median voltage value of U₁, and the preset voltage U of the second battery is a median voltage value of U₂; and calculating a charge capacity difference C₁ of the first battery and the second battery at this point;
calculating a total effective capacity C₃ of active ions in the first battery using formula (I), where formula (I) is as follows: C₃=C₁+C₂; and
calculating active ion replenishment efficiency using formula (II), where formula (II) is as follows: A=(C₃-C₄)/C₅, where C₅ is a theoretical active ion replenishment capacity, C₅=m×k, m is a mass of an additionally provided active ion material, and k is a gram capacity; where when the additionally provided active ion material is lithium metal, k is 3.86 Ah/g; and when the additionally provided active ion material is sodium metal, k is 1.165 Ah/g.

In any embodiment, the evaluation method includes:
providing a reference electrode in each of the first battery and the second battery, and using the reference electrodes to monitor anode potentials of the first battery and the second battery during charging and discharging processes, where both the first battery and the second battery are full cells, the reference electrode is a copper wire, a copper wire with lithium plated on a surface, a copper wire with sodium plated on a surface, a copper wire coated with lithium iron phosphate on a surface, a copper wire coated with lithium titanate on a surface, or a copper wire coated with sodium vanadium phosphate on a surface, a diameter of the copper wire is 50 µm to 100 µm, and a thickness of an active material layer on the copper wire is 10 µm to 50 µm; when the reference electrode is a copper wire, before performing evaluation, using a positive electrode of the first battery as a positive electrode and the copper wire as a negative electrode to perform charging for 1 h at a constant current of 10 µA so as to perform electroplating treatment on the copper wire of the first battery, and using a positive electrode of the second battery as a positive electrode and the copper wire as a negative electrode to perform charging for 1 h at a constant current of 10 µA so as to perform electroplating treatment on the copper wire of the second battery; and when the reference electrode is a copper wire coated with lithium iron phosphate on a surface, a copper wire coated with lithium titanate on a surface, or a copper wire coated with sodium vanadium phosphate on a surface, charging the first battery and the second battery respectively to a battery voltage corresponding to 50±5% SOC so as to activate the reference electrode;
charging and discharging the first battery and the second battery in a nominal voltage range at any rate ranging from 0.02C to 0.1C, acquiring an anode potential-battery voltage curve and an SOC-battery voltage curve of the first battery during discharging, and an anode potential-battery voltage curve and an SOC-battery voltage curve of the second battery, recording a discharge capacity C₄ of the second battery, defining the anode potential-battery voltage curve of the first battery as a first curve, defining the anode potential-battery voltage curve of the second battery as a second curve, defining the SOC-battery voltage curve of the first battery as a third curve, and defining the SOC-battery voltage curve of the second battery as a fourth curve;
determining a battery voltage range U₁₋₁ of the first battery and a battery voltage range U₂₋₁ of the second battery corresponding to portions having identical curve shapes in an identical anode potential range in the first curve and the second curve, where the process of determining U₁₋₁ and U₂₋₁ includes: shifting a voltage value t₁ of the first curve and/or shifting a voltage value t₂ of the second curve along a coordinate line where a battery voltage is located, so that the first curve and the second curve overlap in a battery voltage range U', where t₁ and t₂ are negative values when the shift is performed in a direction toward a lower battery voltage, t₁ and t₂ are positive values when the shift is performed in a direction toward a higher battery voltage, and optionally, t₁ and t₂ satisfy any one or more of the following conditions: 0 V≤|t₁|≤2.0 V, 0 V≤|t₂|≤2.0 V, and 0 V≤|t₁|+|t₂|≤2.0 V; and calculating U₁₋₁ and U₂₋₁ according to the following formulas: U₁₋₁=U'-t₁, and U₂₋₁=U'-t₂;
determining a first battery voltage range U₁₋₂ corresponding to a curve segment in the third curve where a slope does not exceed 400% SOC/battery voltage, and determining a second battery voltage range U₂₋₂ corresponding to a curve segment in the fourth curve where a slope does not exceed 400% SOC/battery voltage;
determining a voltage range U₁ where U₁₋₁ and U₁₋₂ overlap, and determining a voltage range U₂ where U₂₋₁ and U₂₋₂ overlap;
acquiring a discharge capacity C₂ when the first battery is discharged to a nominal lower-limit voltage at any rate ranging from 0.02C to 0.1C, and acquiring a discharge capacity C₄ when the second battery is discharged to an anode potential of 1 V to 2.5 V or discharged until the anode potential reaches an SEI film decomposition potential at any rate ranging from 0.02C to 0.1C; acquiring charge capacities of the first battery and the second battery when the first battery and the second battery are charged respectively to the preset voltages U at any rate ranging from 0.02C to 0.1C, where the preset voltage U of the first battery is a median voltage value of U₁, and the preset voltage U of the second battery is a median voltage value of U₂; and calculating a charge capacity difference C₁ of the first battery and the second battery at this point;
calculating a total effective capacity C₃ of active ions in the first battery using formula (I), where formula (I) is as follows: C₃=C₁+C₂; and
calculating active ion replenishment efficiency A using formula (II), where formula (II) is as follows: A=(C₃-C₄)/C₅, where C₅ is a theoretical active ion replenishment capacity, C₅=m×k, m is a mass of an additionally provided active ion material, and k is a gram capacity; where when the additionally provided active ion material is lithium metal, k is 3.86 Ah/g; and when the additionally provided active ion material is sodium metal, k is 1.165 Ah/g.

In this application, the first battery and the second battery are charged respectively to the preset voltages U such that the two batteries are charged to the identical anode potential, and the charge capacity difference C₁ of the first battery and the second battery is calculated at this point, where C₁ is the capacity difference of the first battery and the second battery caused by lithium replenishment, and the sum of the capacity difference C1 and the foregoing discharge capacity C₂ can accurately characterize the total effective capacity of active ions in the first battery with lithium replenishment.

### BRIEF DESCRIPTION OF DRAWINGS

To describe the technical solutions in the embodiments of this application more clearly, the following briefly describes the accompanying drawings required to be used in the embodiments of this application. Apparently, the accompanying drawings in the following description show merely some embodiments of this application. Those of ordinary skill in the art may still derive other accompanying drawings from the accompanying drawings without creative efforts.
FIG. 1 shows a lithium cycling situation of a second battery during charging and discharging according to an embodiment.
FIG. 2 shows a lithium cycling situation of a first battery during charging and discharging according to an embodiment.
FIG. 3 shows an anode potential-full cell voltage curve graph of a battery with lithium replenishment and a battery without lithium replenishment of LFP in Example 1 of this application.
FIG. 4 shows an SOC-full cell voltage curve graph of a battery with lithium replenishment and a battery without lithium replenishment of LFP in Example 1 of this application.
FIG. 5 shows an anode potential-full cell voltage curve graph of a battery with lithium replenishment and a battery without lithium replenishment of NCM in Example 2 of this application.
FIG. 6 shows an SOC-full cell voltage curve graph of a battery with lithium replenishment and a battery without lithium replenishment of NCM in Example 2 of this application.

### DESCRIPTION OF EMBODIMENTS

The following further describes the embodiments of this application in detail with reference to the accompanying drawings and embodiments. The following detailed description of the embodiments and the accompanying drawings are intended to illustrate the principle of this application, rather than to limit the scope of this application, meaning that this application is not limited to the embodiments described herein.

Embodiments that specifically disclose an evaluation method for an effective replenishment level of active ions in a secondary ion battery in this application are described in detail below with reference to the accompanying drawings as appropriate. However, unnecessary detailed descriptions may be omitted. For example, detailed descriptions of well-known matters and repeated descriptions of actually identical structures may be omitted. This is to avoid the following description from becoming unnecessarily lengthy and to facilitate understanding by those skilled in the art. In addition, the accompanying drawings and the following descriptions are provided for those skilled in the art to fully understand this application and are not intended to limit the subject matter described in the claims.

"Ranges" disclosed in this application are defined in the form of lower and upper limits. A given range is defined by one lower limit and one upper limit selected, where the selected lower and upper limits define boundaries of that particular range. Ranges defined in this way may or may not include end values, and any combination may be used, meaning that any lower limit may be combined with any upper limit to form a range. For example, if ranges of 60-120 and 80-110 are provided for a specific parameter, it is understood that ranges of 60-110 and 80-120 can also be envisioned. In addition, if minimum values of a range are given as 1 and 2, and maximum values of the range are given as 3, 4, and 5, the following ranges can all be envisioned: 1-3, 1-4, 1-5, 2-3, 2-4, and 2-5. In this application, unless otherwise specified, a value range of "a-b" is a short representation of any combination of real numbers between a and b, where both a and b are real numbers. For example, a value range of "0-5" means that all real numbers in the range of "0-5" are listed herein, and "0-5" is just an abbreviated representation of a combination of these numbers. In addition, a parameter expressed as an integer greater than or equal to 2 is equivalent to disclosure that the parameter is, for example, an integer among 2, 3, 4, 5, 6, 7, 8, 9, 10, 11, 12, and so on.

Unless otherwise specified, all the embodiments and optional embodiments of this application can be combined with each other to form new technical solutions.

Unless otherwise specified, all the technical features and optional technical features of this application can be combined with each other to form new technical solutions.

Unless otherwise specified, all steps of this application can be performed sequentially or randomly, and are preferably performed sequentially. For example, the method includes steps (a) and (b), which means that the method may include steps (a) and (b) performed sequentially, or may include steps (b) and (a) performed sequentially. For example, it is mentioned that the method may further include step (c), which means that step (c) can be added to the method in any order. For example, the method may include steps (a), (b), and (c), may include steps (a), (c), and (b), or may include steps (c), (a), and (b).

Unless otherwise specified, "include" and "contain" mentioned in this application mean inclusive. For example, "include" and "contain" may mean that other components not listed may also be included or contained.

Unless otherwise specified, the term "or" in this application is inclusive. For example, any of the following conditions satisfies the condition "A or B": A is true (or present) and B is false (or absent); A is false (or absent) and B is true (or present); or both A and B are true (or present).

This application provides an evaluation method for an effective replenishment level of active ions in a secondary ion battery, where the secondary ion battery is a first battery, and a secondary ion battery without active ion replenishment corresponding to the secondary ion battery is a second battery. The evaluation method includes: acquiring a discharge capacity C₂ of the first battery during discharging in a nominal voltage range; charging the first battery and the second battery to respective preset voltages U, and when an anode potential of the first battery is equal to an anode potential of the second battery at the preset voltages U, calculating a charge capacity difference C₁ of the first battery and the second battery at this point; and calculating a sum C₃ of the charge capacity difference C₁ and the discharge capacity C₂, where C₃ is used to characterize a total effective capacity of active ions in the first battery.

The above secondary ion battery is also called a rechargeable battery or a storage battery, and refers to a battery whose active material can be activated for continuous use through charging after the battery is discharged.

Typically, a secondary ion battery includes a cathode electrode plate, an anode electrode plate, a separator, and an electrolyte. During charging and discharging process of the battery, active ions (such as lithium ions) are intercalated and deintercalated back and forth between the cathode electrode plate and the anode electrode plate. The separator is disposed between the cathode electrode plate and the anode electrode plate to mainly prevent short circuits between a cathode and an anode and to allow the active ions to pass through. The electrolyte is located between the cathode electrode plate and the anode electrode plate, mainly playing a role of conducting active ions.

The above first battery and second battery have the same battery design and production process except for lithium replenishment and non-lithium replenishment. A certain difference is allowed to be present in widths and lengths of electrode plates of the first battery and the second battery. All capacities applied in this application are obtained by normalizing capacities of the battery during charging and discharging processes by using a true area of the cathode electrode plate.

In this application, the first battery and the second battery are charged respectively to the preset voltages U such that the two batteries are charged to the identical anode potential, and the charge capacity difference C₁ of the first battery and the second battery is calculated at this point, where C₁ is the capacity difference of the first battery and the second battery caused by lithium replenishment, and the sum of the capacity difference C1 and the foregoing discharge capacity C₂ can accurately characterize the total effective capacity of active ions in the first battery with lithium replenishment.

According to the working mechanism of a conventional secondary ion battery, in some embodiments, the preset voltage typically falls within a range of 2.8 V to 3.8 V.

The principle of the above evaluation method of this application is described below with reference to the accompanying drawings.

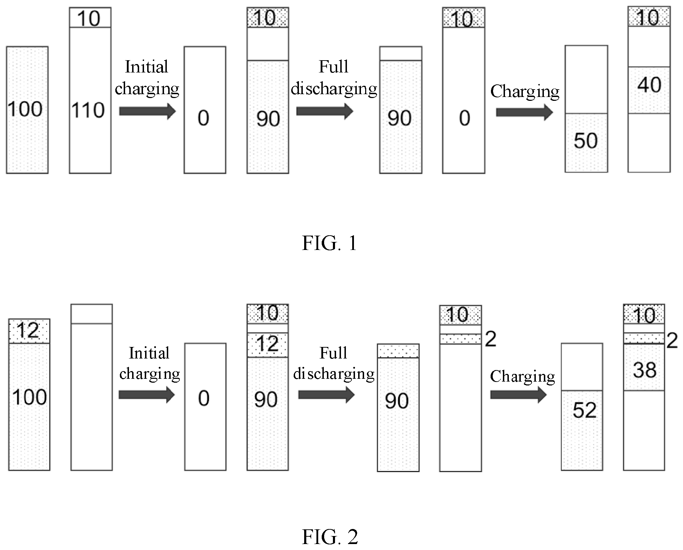

FIG. 1 shows a lithium cycling situation of a second battery during charging and discharging according to an embodiment. As shown in FIG. 1, filled positions represent lithium, a cathode contains 100 lithium ions, an anode has 110 vacancies (that is, reversible vacancies of the anode) available for lithium deintercalation, and 10 lithium vacancies required for SEI formation. During initial charging, 100 lithium ions are deintercalated from the cathode, where 10 lithium ions are used for SEI film formation, and 90 lithium ions are stored in the reversible vacancies of the anode. During full discharging, 90 lithium ions are deintercalated to the cathode. During recharging, an anode potential is controlled so that 40 lithium ions are intercalated into the anode. The anode potential represents an actual SOC of the anode, and the actual SOC is equal to lithium intercalated into the anode/total reversible vacancies. In FIG. 1, SOC is equal to 40/100=40%.

FIG. 2 shows a lithium cycling situation of a first battery during charging and discharging according to an embodiment. As shown in FIG. 2, filled positions represent lithium, a cathode contains 112 lithium ions (including 12 replenished lithium ions), the anode has 110 vacancies (that is, reversible vacancies of the anode) available for lithium deintercalation, and 10 lithium vacancies required for SEI formation. During initial charging, 112 lithium ions are deintercalated from the cathode, where 10 lithium ions are used for SEI film formation, and 102 lithium ions are stored in the reversible vacancies of the anode. During full discharging, 100 lithium ions are deintercalated to the cathode. During recharging, the anode potential is controlled so that a total of 40 lithium ions are intercalated into the anode, that is, an actual SOC is equal to lithium intercalated into the anode/total reversible vacancies. In FIG. 2, SOC is equal to 40/100=40%.

At this point, the active lithium C₃ of the battery with lithium replenishment is equal to C₂+C₁=100+(40-38)=102.

Voltages corresponding to a range where the anode potential-battery voltage curves of the first battery and the second battery have identical shapes can be selected as the preset voltages U, thereby ensuring that when charged to the preset voltages U, the actual anode potentials of the first battery and the second battery are more accurately equal to each other.

In some embodiments of this application, the above evaluation method includes:
acquiring curves, including: acquiring a first curve and a second curve of the first battery and the second battery during a charging process or a discharging process in a nominal voltage range, and the discharge capacity C₂ of the first battery, where both the first curve and the second curve are full charging process curves or full discharging process curves, the first curve is an anode potential-battery voltage curve of the first battery, and the second curve is an anode potential-battery voltage curve of the second battery;
acquiring a voltage range U₁, including: determining a battery voltage range U₁₋₁ of the first battery and a battery voltage range U₂₋₁ of the second battery corresponding to portions having identical curve shapes in an identical anode potential range in the first curve and the second curve;
acquiring a capacity difference C₁, including: acquiring charge capacities of the first battery and the second battery when the first battery and the second battery are charged to the respective preset voltages U, where the preset voltage U of the first battery is any value in U₁₋₁, and the preset voltage U of the second battery is any value in U₂₋₁; and calculating the charge capacity difference C₁ of the first battery and the second battery at this point; and
acquiring a total effective replenishment capacity of active ions, including: calculating a sum C₃ of the charge capacity difference C₁ and the discharge capacity C₂.

The preset voltage U is determined in the above method, and the charge capacity difference C₁ obtained at this point is closer to a true level. When the battery voltage range U₁₋₁ and the battery voltage range U₂₋₁ overlap, the preset voltage of the first battery and the preset voltage of the second battery may be the same.

In the above process of acquiring the capacity difference C₁, the charge capacities of the first battery and the second battery may be the charge capacities corresponding to charging to the voltage U in the process of acquiring the above curves, so the process of acquiring the capacity difference C₁ may not require recharging. Certainly, separate charging may also be performed according to the above conditions to acquire the charge capacities of the first battery and the second battery.

In some embodiments of this application, the process of acquiring the capacity difference C₁ includes: discharging the first battery and the second battery respectively and then charging the first battery and the second battery to the respective preset voltages U, and calculating the charge capacity difference C₁ of the first battery and the second battery at this point, where the first battery is discharged to a nominal lower-limit voltage, and the second battery is discharged to 1 V to 2.5 V or discharged until the anode potential reaches an SEI film decomposition potential.

The above SEI film decomposition potential may be subjected to the conventional dQ/dV test in the art to determine an accurate SEI decomposition potential. This is not further described in this application.

The first battery with lithium replenishment has more anode active lithium, and the cathode is subjected to lithium intercalation to a low voltage during discharging, resulting in a significant polarization at this point. Therefore, after the first battery is discharged with respect to the second battery, a larger amount of active lithium remains in the anode. Therefore, the first battery is discharged to the nominal lower-limit voltage such that the first battery is fully discharged as much as possible, thereby alleviating the problem that active lithium that can be deintercalated remains in the anode due to insufficient discharge, which otherwise results in an excessively low total effective capacity of active ions in the first battery.

In some embodiments, a discharge rate is any rate selected from 0.02C to 0.1C. Discharging at the above low rate makes it easier to accurately control a discharge cut-off voltage, and the obtained capacity difference C₁ is more accurate.

In some embodiments, the first battery and the second battery are charged respectively to the preset voltages U at any rate ranging from 0.02C to 0.1C. Charging at the above low rate makes it easier to accurately control a charge cut-off voltage.

The above preset voltage U may be any value in U₁. In some embodiments, the preset voltage U of the first battery is a median voltage value of U₁₋₁, and the preset voltage U of the second battery is a median voltage value of U₂₋₁.

Due to different battery systems, the first curve and the second curve of the first battery and the second battery may not be able to overlap in situ. In some embodiments, the process of determining U₁₋₁ and U₂₋₁ includes: shifting a voltage value t₁ of the first curve and/or shifting a voltage value t₂ of the second curve along a coordinate line where a battery voltage is located, so that the first curve and the second curve overlap in a battery voltage range U', where t₁ and t₂ are negative values when the shift is performed in a direction toward a lower battery voltage, and t₁ and t₂ are positive values when the shift is performed in a direction toward a higher battery voltage, and optionally, t₁ and t₂ satisfy any one or more of the following conditions: 0 V≤|t₁|≤2.0 V, 0 V≤|t₂|≤2.0 V, and 0 V≤|t₁|+|t₂|≤2.0 V; and calculating U₁₋₁ and U₂₋₁ according to the following formulas: U₁₋₁=U'-t₁, and U₂₋₁=U'-t₂. Thus, more accurate U₁₋₁ and U₂₋₁ are obtained.

In some embodiments, the process of acquiring the curves further includes a process of acquiring a third curve and a fourth curve during a charging process or a discharging process in a nominal voltage range, where both the third curve and the fourth curve are full charging process curves or full discharging process curves, the third curve is an SOC-battery voltage curve of the first battery, and the fourth curve is an SOC-battery voltage curve of the second battery. The evaluation method further includes: determining a first battery voltage range U₁₋₂ corresponding to a curve segment in the third curve where a slope does not exceed 400% SOC/battery voltage, and determining a second battery voltage range U₂₋₂ corresponding to a curve segment in the fourth curve where a slope does not exceed 400% SOC/battery voltage; determining a voltage range U₁ where U₁₋₁ and U₂₋₁ overlap; and determining a voltage range U₂ where U₁₋₂ and U₂₋₂ overlap; where in the process of acquiring the charge capacity difference C1, the preset voltage U of the first battery is any value in U₁, and the preset voltage U of the second battery is any value in U₂.

Factors such as the accuracy of charging and discharging devices cause deviations between the actual charge cut-off voltage and the preset voltage U. When the slope of the SOC-battery voltage curve is low, the resulting SOC deviation is small, so the influence on C1 is small. When the slope does not exceed 400% SOC/battery voltage, it indicates that the slope of the curve segment is low, which means that even if there is a certain difference between the charge cut-off voltage and the preset voltage of the battery, the corresponding capacity difference C₁ is less affected by the charging and discharging, and the charging and discharging difference obtained can correspond as much as possible to the difference caused by lithium replenishment.

In some embodiments of this application, the preset voltage U of the first battery is a median voltage value of U₁, and the preset voltage U of the second battery is a median voltage value of U₂.

In some embodiments, the above process of acquiring the curves includes: performing charging treatment or discharging treatment on the first battery and the second battery respectively at an identical rate in the nominal voltage range to acquire the first curve and the second curve.

In some embodiments, a rate of the charging process or the discharging process is any rate selected from 0.02C to 0.1C. The charging process or discharging process is performed at the above low rate, which improves the accuracy of the curves.

In some embodiments, the above evaluation method further includes a step of recording a discharge capacity C₄ of the second battery; and the evaluation method further includes a process of calculating active ion replenishment efficiency, where the active ion replenishment efficiency is denoted as A=(C₃-C₄)/C₅, and C₅ is a theoretical active ion replenishment capacity. The above theoretical active ion replenishment capacity can be calculated by C₅=m×k, where m is a mass of an additionally provided active ion material, and k is a gram capacity; where when the additionally provided active ion material is lithium metal, k is 3.86 Ah/g; and when the additionally provided active ion material is sodium metal, k is 1.165 Ah/g.

The evaluation method of this application needs to obtain an accurate anode potential. To simplify the test method of the anode potential, in some embodiments, the first battery and the second battery are each provided with a reference electrode, and the reference electrodes are used to monitor anode potentials of the first battery and the second battery during charging and discharging. The reference electrode is disposed in the battery. For example, the reference electrode is disposed between the cathode and the anode and separated from the cathode and anode by the separator.

In some embodiments, the above reference electrode is a conductive wire with an active material layer on a surface, a diameter of the conductive wire is 50 µm to 100 µm, and a thickness of the active material layer is 10 µm to 50 µm. The conductive wire is preferably a metal wire, such as a copper wire. The active material layer may be an active metal layer or an active metal compound layer.

In some embodiments, the reference electrode is a copper wire, a copper wire with a lithium-plated layer on a surface, a copper wire with a sodium-plated layer on a surface, a copper wire coated with a lithium iron phosphate layer on a surface, a copper wire coated with a lithium titanate layer on a surface, or a copper wire coated with a sodium vanadium phosphate layer on a surface.

In some embodiments, when the reference electrode is a copper wire, before evaluation is performed, an active metal layer is plated on its surface. For example, a positive electrode of the first battery is used as a positive electrode, the copper wire is used as the negative electrode, and charging is performed for 1 h at a constant current of 10 µA to perform electroplating treatment on the copper wire of the first battery; and a positive electrode of the second battery is used as a positive electrode, the copper wire is used as a negative electrode, and charging is performed for 1 h at a constant current of 10 µA to perform electroplating treatment on the copper wire of the second battery.

In some embodiments, when the reference electrode is a copper wire coated with a lithium iron phosphate layer on a surface, a copper wire coated with a lithium titanate layer on a surface, or a copper wire coated with a sodium vanadium phosphate layer on a surface, the evaluation method further includes a process of first activating the reference electrode, where the process of activating the reference electrode includes: charging the first battery and the second battery respectively to a battery voltage corresponding to 50±5% SOC.

To further improve the accuracy of the evaluation, in some embodiments, both the first battery and the second battery are full cells, and the secondary ion battery is a lithium-ion secondary battery or a sodium-ion secondary battery. Direct measurement using a full cell is adopted, so that the charging and discharging process can completely simulate the actual working process of the battery, and the evaluation result is more accurate.

In some embodiments of this application, the above evaluation method includes:
providing a reference electrode in each of the first battery and the second battery, and using the reference electrodes to monitor anode potentials of the first battery and the second battery during charging and discharging, where both the first battery and the second battery are full cells, the reference electrode is a copper wire, a copper wire with a lithium-plated layer on a surface, a copper wire with a sodium-plated layer on a surface, a copper wire coated with a lithium iron phosphate layer on a surface, a copper wire coated with a lithium titanate layer on a surface, or a copper wire coated with a sodium vanadium phosphate layer on a surface, a diameter of the copper wire is 50 µm to 100 µm, and a thickness of the active material layer on the copper wire is 10 µm to 50 µm; when the reference electrode is a copper wire, plating an active metal layer on its surface, for example, using a positive electrode of the first battery as a positive electrode and the copper wire as the negative electrode to perform charging for 1 h at a constant current of 10 µA so as to perform electroplating treatment on the copper wire of the first battery, and using a positive electrode of the second battery as the positive electrode and the copper wire as a negative electrode to perform charging for 1 h at a constant current of 10 µA so as to perform electroplating treatment on the copper wire of the second battery; and when the reference electrode is a copper wire coated with lithium iron phosphate on a surface, a copper wire coated with lithium titanate on a surface, or a copper wire coated with sodium vanadium phosphate on a surface, charging the first battery and the second battery respectively to a battery voltage corresponding to 50±5% SOC so as to activate the reference electrode;
charging the first battery and the second battery in a nominal voltage range at any rate ranging from 0.02C to 0.1C, acquiring an anode potential-battery voltage curve and an SOC-battery voltage curve of the first battery, and an anode potential-battery voltage curve and an SOC-battery voltage curve of the second battery, defining the anode potential-battery voltage curve of the first battery as a first curve, defining the anode potential-battery voltage curve of the second battery as a second curve, defining the SOC-battery voltage curve of the first battery as a third curve, and defining the SOC-battery voltage curve of the second battery as a fourth curve;
determining a battery voltage range U₁₋₁ of the first battery and a battery voltage range U₂₋₁ of the second battery corresponding to portions having identical curve shapes in an identical anode potential range in the first curve and the second curve, where the process of determining U₁₋₁ and U₂₋₁ includes: shifting a voltage value t₁ of the first curve and/or shifting a voltage value t₂ of the second curve along a coordinate line where the battery voltage is located, so that the first curve and the second curve overlap in a battery voltage range U', where t₁ and t₂ are negative values when the shift is performed in a direction toward a lower battery voltage, t₁ and t₂ are positive values when the shift is performed in a direction toward a higher battery voltage, and optionally, t₁ and t₂ satisfy any one or more of the following conditions: 0 V≤|t₁|≤2.0 V, 0 V≤|t₂|≤2.0 V, and 0 V≤|t₁|+|t₂|≤2.0 V; and calculating U₁₋₁ and U₂₋₁ according to the following formulas: U₁₋₁=U'-t₁, and U₂₋₁=U'-t₂;
determining a first battery voltage range U₁₋₂ corresponding to a curve segment in the third curve where a slope does not exceed 400% SOC/battery voltage, and determining a second battery voltage range U₂₋₂ corresponding to a curve segment in the fourth curve where a slope does not exceed 400% SOC/battery voltage;
determining a voltage range U₁ where U₁₋₁ and U₁₋₂ overlap, and determining a voltage range U₂ where U₂₋₁ and U₂₋₂ overlap;
discharging the first battery and the second battery, where a discharge rate is any rate selected from 0.02C to 0.1C, the first battery is discharged to a nominal lower-limit voltage, and the second battery is discharged to 1 V to 2.5 V or discharged until the anode potential reaches an SEI film decomposition potential; recording a discharge capacity C₂ of the first battery and a discharge capacity C₄ of the second battery; acquiring charge capacities of the first battery and the second battery when the first battery and the second battery are charged respectively to the preset voltages U at any rate ranging from 0.02C to 0.1C, where the preset voltage U of the first battery is a median voltage value of U₁, and the preset voltage U of the second battery is a median voltage value of U₂; and calculating a charge capacity difference C₁ of the first battery and the second battery at this point;
calculating a total effective replenishment capacity C₃ of active ions in the first battery using formula (I), where formula (I) is as follows: C₃=C₁+C₂; and
calculating active ion replenishment efficiency using formula (II), where formula (II) is as follows: A=(C₃-C₄)/C₅, where C₅ is a theoretical active ion replenishment capacity, C₅=m×k, m is a mass of an additionally provided active ion material, and k is a gram capacity; where when the additionally provided active ion material is lithium metal, k is 3.86 Ah/g; and when the additionally provided active ion material is sodium metal, k is 1.165 Ah/g.

In the above process of acquiring the capacity difference C₁, the charge capacities of the first battery and the second battery may be the charge capacities corresponding to charging to the voltage U in the process of acquiring the first curve to the fourth curve, so the process of acquiring the capacity difference C₁ may not require recharging. Certainly, separate charging may also be performed according to the above conditions to acquire the charge capacities of the first battery and the second battery.

In some embodiments of this application, the above evaluation method includes:
providing a reference electrode in each of the first battery and the second battery, and using the reference electrodes to monitor anode potentials of the first battery and the second battery during charging and discharging, where both the first battery and the second battery are full cells, the reference electrode is a copper wire, a copper wire with a lithium-plated layer on a surface, a copper wire with a sodium-plated layer on a surface, a copper wire coated with a lithium iron phosphate layer on a surface, a copper wire coated with a lithium titanate layer on a surface, or a copper wire coated with a sodium vanadium phosphate layer on a surface, a diameter of the copper wire is 50 µm to 100 µm, and a thickness of the active material layer on the copper wire is 10 µm to 50 µm; when the reference electrode is a copper wire, before performing evaluation, using a positive electrode of the first battery as a positive electrode and the copper wire as a negative electrode to perform charging for 1 h at a constant current of 10 µA so as to perform electroplating treatment on the copper wire of the first battery, and using a positive electrode of the second battery as a positive electrode and the copper wire as a negative electrode to perform charging for 1 h at a constant current of 10 µA so as to perform electroplating treatment on the copper wire of the second battery; and when the reference electrode is a copper wire coated with a lithium iron phosphate layer on a surface, a copper wire coated with a lithium titanate layer on a surface, or a copper wire coated with a sodium vanadium phosphate layer on a surface, charging the first battery and the second battery respectively to a battery voltage corresponding to 50±5% SOC so as to activate the reference electrode;
charging and discharging the first battery and the second battery in a nominal voltage range at any rate ranging from 0.02C to 0.1C, acquiring an anode potential-battery voltage curve and an SOC-battery voltage curve of the first battery during discharging, and an anode potential-battery voltage curve and an SOC-battery voltage curve of the second battery, recording a discharge capacity C₄ of the second battery, defining the anode potential-battery voltage curve of the first battery as a first curve, defining the anode potential-battery voltage curve of the second battery as a second curve, defining the SOC-battery voltage curve of the first battery as a third curve, and defining the SOC-battery voltage curve of the second battery as a fourth curve;
determining a battery voltage range U₁₋₁ of the first battery and a battery voltage range U₂₋₁ of the second battery corresponding to portions having identical curve shapes in an identical anode potential range in the first curve and the second curve, where the process of determining U₁₋₁ and U₂₋₁ includes: shifting a voltage value t₁ of the first curve and/or shifting a voltage value t₂ of the second curve along a coordinate line where a battery voltage is located, so that the first curve and the second curve overlap in a battery voltage range U', where t₁ and t₂ are negative values when the shift is performed in a direction toward a lower battery voltage, t₁ and t₂ are positive values when the shift is performed in a direction toward a higher battery voltage, and optionally, t₁ and t₂ satisfy any one or more of the following conditions: 0 V≤|t₁|≤2.0 V, 0 V≤|t₂|≤2.0 V, and 0 V≤|t₁|+|t₂|≤2.0 V; and calculating U₁₋₁ and U₂₋₁ according to the following formulas: U₁₋₁=U'-t₁, and U₂₋₁=U'-t₂;
determining a first battery voltage range U₁₋₂ corresponding to a curve segment in the third curve where a slope does not exceed 400% SOC/battery voltage, and a second battery voltage range U₂₋₂ corresponding to a curve segment in the fourth curve where a slope does not exceed 400% SOC/battery voltage;
determining a voltage range U₁ where U₁₋₁ and U₁₋₂ overlap, and determining a voltage range U₂ where U₂₋₁ and U₂₋₂ overlap;
acquiring a discharge capacity C₂ when the first battery is discharged to a nominal lower-limit voltage at any rate ranging from 0.02C to 0.1C, and acquiring a discharge capacity C₄ when the second battery is discharged to 1 V to 2.5 V or discharged until the anode potential reaches an SEI film decomposition potential; acquiring charge capacities of the first battery and the second battery when the first battery and the second battery are charged respectively to the preset voltages U at any rate ranging from 0.02C to 0.1C, where the preset voltage U of the first battery is a median voltage value of U₁, and the preset voltage U of the second battery is a median voltage value of U₂; and calculating a charge capacity difference C₁ of the first battery and the second battery at this point;
calculating a total effective replenishment capacity C₃ of active ions in the first battery using formula (I), where formula (I) is as follows: C₃=C₁+C₂; and
calculating active ion replenishment efficiency A using formula (II), where formula (II) is as follows: A=(C₃-C₄)/C₅, where C₅ is a theoretical active ion replenishment capacity, C₅=m×k, m is a mass of an additionally provided active ion material, and k is a gram capacity; where when the additionally provided active ion material is lithium metal, k is 3.86 Ah/g; and when the additionally provided active ion material is sodium metal, k is 1.165 Ah/g.

The above discharge capacity C₂ may be the discharge capacity obtained when the first battery is discharged to the nominal lower-limit voltage in the process of acquiring the first curve to the fourth curve. Certainly, the above discharge capacity C₂ may alternatively be the corresponding capacity during separate discharge according to the above conditions. The above discharge capacity C₄ may be the discharge capacity obtained when the second battery is discharged to the above voltage in the process of acquiring the first curve to the fourth curve. Certainly, the above discharge capacity C₄ may alternatively be the corresponding capacity during separate discharge according to the above conditions. In the above process of acquiring the capacity difference C₁, the charge capacities of the first battery and the second battery may be the charge capacities corresponding to charging to the voltage U in the above process of acquiring the first curve to the fourth curve, so the process of acquiring the capacity difference C₁ may not require recharging. Certainly, separate charging may also be performed according to the above conditions to acquire the charge capacities of the first battery and the second battery.

The above evaluation method of this application is applicable to the evaluation of secondary ion batteries of any composition, and the evaluation method of this application can be used to evaluate whether the secondary ion battery is subjected to cathode lithium replenishment, anode lithium replenishment, electrolyte lithium replenishment, or separator lithium replenishment.

The composition of each part of the secondary ion battery is exemplarily described below.

### [Cathode electrode plate]

The cathode electrode plate typically includes a cathode electrode current collector and a cathode electrode film layer provided on at least one surface of the cathode electrode current collector, and the cathode electrode film layer includes a cathode electrode active material.

As an example, the cathode electrode current collector has two opposite surfaces in its thickness direction, and the cathode electrode film layer is provided on either or both of the two opposite surfaces of the cathode electrode current collector.

In some embodiments, the cathode electrode current collector may use a metal foil or a composite current collector. For example, as the metal foil, an aluminum foil may be used. The composite current collector may include a polymer material substrate and a metal layer formed on at least one surface of the polymer material substrate. The composite current collector may be formed by forming a metal material (aluminum, aluminum alloy, nickel, nickel alloy, titanium, titanium alloy, silver, silver alloy, or the like) on a polymer material substrate (such as polypropylene (PP), polyethylene terephthalate (PET), polybutylene terephthalate (PBT), polystyrene (PS), or polyethylene (PE)).

In some embodiments, the cathode electrode active material may use cathode electrode active materials for batteries known in the art. As an example, when the secondary battery is a lithium-ion secondary battery, the cathode electrode active material may include at least one of the following materials: lithium-containing phosphate with an olivine structure, lithium transition metal oxide, and their respective modified compounds. However, this application is not limited to these materials, and other conventional materials that can be used as cathode electrode active materials for batteries may also be used. These cathode electrode active materials may be used alone or in combination of two or more. Examples of lithium transition metal oxide may include but are not limited to at least one of lithium cobalt oxide (such as LiCoO₂), lithium nickel oxide (such as LiNiO₂), lithium manganese oxide (such as LiMnO₂ or LiMn₂O₄), lithium nickel cobalt oxide, lithium manganese cobalt oxide, lithium nickel manganese oxide, lithium nickel cobalt manganese oxide (such as LiNi_{1/3}Co_{1/3}Mn_{1/3}O₂ (which may also be abbreviated as NCM333), LiNi_{0.5}Co_{0.2}Mn_{0.3}O₂ (which may also be abbreviated as NCM523), LiNi_{0.5}Co_{0.25}Mn_{0.25}O₂ (which may also be abbreviated as NCM211), LiNi_{0.6}Co_{0.2}Mn_{0.2}O₂ (which may also be abbreviated as NCM622), LiNi_{0.8}Co_{0.1}Mn_{0.1}O₂ (which may also be abbreviated as NCM811), lithium nickel cobalt aluminum oxide (such as LiNi_{0.85}Co_{0.15}Al_{0.05}O₂)), and their modified compounds. Examples of lithium-containing phosphate with an olivine structure may include but are not limited to at least one of lithium iron phosphate (such as LiFePO₄ (which may also be abbreviated as LFP)), a composite material of lithium iron phosphate and carbon, lithium manganese phosphate (such as LiMnPO₄), a composite material of lithium manganese phosphate and carbon, lithium manganese iron phosphate, and a composite material of lithium manganese iron phosphate and carbon.

When the secondary battery is a sodium-ion secondary battery, as an example, the cathode electrode active material of the sodium-ion secondary battery may include at least one of the following materials: a sodium transition metal oxide, a polyanionic compound, and a Prussian blue compound. However, this application is not limited to these materials, and other conventional and well-known materials that can be used as cathode electrode active materials for sodium-ion batteries may also be used.

As an optional technical solution of this application, in the sodium transition metal oxide, the transition metal may be at least one of Mn, Fe, Ni, Co, Cr, Cu, Ti, Zn, V, Zr, and Ce. The sodium transition metal oxide is, for example, NaₓMO₂, where M is one or more of Ti, V, Mn, Co, Ni, Fe, Cr, and Cu, and 0<x≤1.

As an optional technical solution of this application, the polyanionic compound may be a type of compounds having sodium ions, transition metal ions, and tetrahedral (YO₄)ⁿ⁻ anion units. The transition metal may be at least one of Mn, Fe, Ni, Co, Cr, Cu, Ti, Zn, V, Zr, and Ce; Y may be at least one of P, S, and Si; and n represents the valence state of (YO₄)ⁿ⁻.

The polyanionic compound may alternatively be a type of compounds having sodium ions, transition metal ions, tetrahedral (YO₄)ⁿ⁻ anion units, and halogen anions. The transition metal may be at least one of Mn, Fe, Ni, Co, Cr, Cu, Ti, Zn, V, Zr, and Ce; Y may be at least one of P, S, and Si; n represents the valence state of (YO₄)ⁿ⁻; and the halogen may be at least one of F, Cl, and Br.

The polyanionic compound may alternatively be a type of compounds having sodium ions, tetrahedral (YO₄)ⁿ⁻ anion units, polyhedral units (ZO_{y})^{m+}, and optional halogen anions. Y may be at least one of P, S, and Si; n represents the valence state of (YO₄)ⁿ⁻; Z represents a transition metal and may be at least one of Mn, Fe, Ni, Co, Cr, Cu, Ti, Zn, V, Zr, and Ce; m represents the valence state of (ZO_{y})^{m+}; and the halogen may be at least one of F, Cl, and Br.

The polyanionic compound is, for example, at least one of NaFePO₄, Na₃V₂(PO₄)₃ (3 sodium vanadium phosphate, abbreviated as NVP), Na₄Fe₃(PO₄)₂(P₂O₇), NaM'PO₄F (M' is one or more of V, Fe, Mn, and Ni), and Na₃(VO_{y})₂(PO₄)₂F_{3-2y} (0≤y≤1).

The Prussian blue compound may be a type of compounds having sodium ions, transition metal ions, and cyanide ions (CN-). The transition metal may be at least one of Mn, Fe, Ni, Co, Cr, Cu, Ti, Zn, V, Zr, and Ce. The Prussian blue compound is, for example, NaₐMe_{b}Me'_{c}(CN)₆, where Me and Me' are each independently at least one of Ni, Cu, Fe, Mn, Co, and Zn, 0<a≤2, 0<b<1, and 0<c<1.

In some embodiments, the cathode electrode film layer further optionally includes a binder. As an example, the binder may include at least one of polyvinylidene fluoride (PVDF), polytetrafluoroethylene (PTFE), vinylidene fluoride-tetrafluoroethylene-propylene terpolymer, vinylidene fluoride-hexafluoropropylene-tetrafluoroethylene terpolymer, tetrafluoroethylene-hexafluoropropylene copolymer, and fluorine-containing acrylate resin.

In some embodiments, the cathode electrode film layer further optionally includes a conductive agent. As an example, the conductive agent may include at least one of superconducting carbon, acetylene black, carbon black, Ketjen black, carbon dots, carbon nanotubes, graphene, and carbon nanofiber.

In some embodiments, the cathode electrode plate may be prepared in the following method: the components used for preparing the cathode electrode plate, such as the cathode electrode active material, the conductive agent, the binder, and any other components, are dispersed in a solvent (such as N-methylpyrrolidone) to form a cathode electrode slurry. Then, the cathode electrode slurry is applied on the cathode electrode current collector, followed by processes such as drying and cold pressing, to obtain the cathode electrode plate.

### [Anode electrode plate]

The anode electrode plate includes an anode electrode current collector and an anode electrode film layer provided on at least one surface of the anode electrode current collector, and the anode electrode film layer includes an anode electrode active material.

As an example, the anode electrode current collector has two opposite surfaces in its thickness direction, and the anode electrode film layer is provided on either or both of the two opposite surfaces of the anode electrode current collector.

In some embodiments, the anode electrode current collector may use a metal foil or a composite current collector. For example, as the metal foil, a copper foil may be used. The composite current collector may include a polymer material substrate and a metal layer formed on at least one surface of the polymer material substrate. The composite current collector may be formed by forming a metal material (copper, copper alloy, nickel, nickel alloy, titanium, titanium alloy, silver, silver alloy, or the like) on a polymer material substrate (such as polypropylene (PP), polyethylene terephthalate (PET), polybutylene terephthalate (PBT), polystyrene (PS), or polyethylene (PE)).

In some embodiments, the anode electrode active material may use anode electrode active materials for batteries known in the art. As an example, the anode electrode active material may include at least one of the following materials: artificial graphite, natural graphite, soft carbon, hard carbon, a silicon-based material, a tin-based material, lithium titanate, and the like. The silicon-based material may be selected from at least one of elemental silicon, a silicon-oxygen compound, a silicon-carbon composite, a silicon-nitrogen composite, and a silicon alloy. The tin-based material may be selected from at least one of elemental tin, a tin-oxygen compound, and a tin alloy. However, this application is not limited to these materials, and other conventional materials that can be used as anode electrode active materials for batteries may also be used. These anode electrode active materials may be used alone or in combination of two or more.

In some embodiments, the anode electrode film layer further optionally includes a binder. As an example, the binder may be selected from at least one of styrene-butadiene rubber (SBR), polyacrylic acid (PAA), sodium polyacrylate (PAAS), polyacrylamide (PAM), polyvinyl alcohol (PVA), sodium alginate (SA), polymethacrylic acid (PMAA), and carboxymethyl chitosan (CMCS).

In some embodiments, the anode electrode film layer further optionally includes a conductive agent. As an example, the conductive agent may be selected from at least one of superconducting carbon, acetylene black, carbon black, Ketjen black, carbon dots, carbon nanotubes, graphene, and carbon nanofiber.

In some embodiments, the anode electrode film layer further optionally includes other additives, such as a thickener (such as sodium carboxymethyl cellulose (CMC-Na)).

In some embodiments, the anode electrode plate may be prepared in the following method: the components used for preparing the anode electrode plate, such as the anode electrode active material, the conductive agent, the binder, and any other components, are dispersed in a solvent (such as deionized water) to form an anode electrode slurry. Then, the anode electrode slurry is applied on the anode electrode current collector, followed by drying and cold pressing, to obtain the anode electrode plate.

### [Electrolyte]

The electrolyte plays a role of conducting ions between the cathode electrode plate and the anode electrode plate. The type of the electrolyte is not specifically limited in this application, which can be selected according to the needs. For example, the electrolyte may be in a liquid state, a gel state, or an all-solid-state.

In some embodiments, the electrolyte is in a liquid state and includes an electrolytic salt and a solvent.

In some embodiments, the electrolytic salt may be selected from at least one of lithium hexafluorophosphate, lithium tetrafluoroborate, lithium perchlorate, lithium hexafluoroarsenate, lithium bis(fluorosulfonyl)imide, lithium bis(trifluoromethanesulfonyl)imide, lithium trifluoromethanesulfonate, lithium difluorophosphate, lithium difluoro(oxalato)borate, lithium bis(oxalato)borate, lithium difluorobis(oxalato)phosphate, and lithium tetrafluoro(oxalato)phosphate.

In some embodiments, the solvent may be selected from at least one of ethylene carbonate, propylene carbonate, ethyl methyl carbonate, diethyl carbonate, dimethyl carbonate, dipropyl carbonate, methyl propyl carbonate, ethyl propyl carbonate, butylene carbonate, fluoroethylene carbonate, methyl formate, methyl acetate, ethyl acetate, propyl acetate, methyl propionate, ethyl propionate, propyl propionate, methyl butyrate, ethyl butyrate, 1,4-butyrolactone, sulfolane, dimethyl sulfone, ethyl methyl sulfone, and diethyl sulfone.

In some embodiments, the electrolyte further optionally includes an additive. As an example, the additive may include an anode electrode film-forming additive and a cathode electrode film-forming additive, or may include an additive that can improve some performance of the battery, for example, an additive for improving overcharge performance of the battery and an additive for improving high-temperature performance or low-temperature performance of the battery.

### [Separator]

In some embodiments, the secondary battery further includes a separator. The type of the separator is not particularly limited in this application, and any well-known porous separator with good chemical stability and mechanical stability may be selected.

In some embodiments, a material of the separator may be selected from at least one of glass fiber, nonwoven fabric, polyethylene, polypropylene, and polyvinylidene fluoride. The separator may be a single-layer film or a multi-layer composite film, without particular restriction. When the separator is a multi-layer composite film, materials of layers may be the same or different, without particular restriction.

In some embodiments, the cathode electrode plate, the anode electrode plate, and the separator may be made into an electrode assembly through a winding process or a lamination process.

In some embodiments, the secondary battery includes a secondary battery cell, or includes a battery module and a battery pack.

### [Examples]

Examples of this application are described in detail below. The examples are illustrative and intended to explain this application, but should not be construed as limitations on this application. Examples whose technical solutions or conditions are not specified are made in accordance with technical solutions or conditions described in literature in the field or made in accordance with product instructions. The reagents or instruments used are all conventional products that are commercially available if no manufacturer is indicated.

### Example 1: Evaluation of LFP secondary battery

Both a battery with lithium replenishment and a battery without lithium replenishment were full cells and were each internally provided with a reference electrode copper wire. A diameter of the copper wire was 50 µm. A positive electrode material was lithium iron phosphate (LFP). A positive electrode current collector was an aluminum foil. A weight ratio of LFP, a conductive agent acetylene black, and a binder PVDF in a positive electrode film layer was 94:4:2. A negative electrode material was graphite. A negative electrode current collector was a copper foil. A weight ratio of graphite, a conductive agent acetylene black, a binder styrene-butadiene rubber (SBR), and carboxymethyl cellulose (CMC) in a negative electrode film layer was 95:1.5:3.1:0.4. In composition of an electrolyte, a solvent was formed by ethylene carbonate (EC), propylene carbonate (PC), and dimethyl carbonate (DMC) at a weight ratio of EC:PC:DMC=3:3:3. A concentration of a lithium salt LiPF₆ in the electrolyte was 1 mol/L. A polyethylene porous film with a thickness of 12 µm was used as a separator. A first battery was subjected to lithium replenishment at a positive electrode. A lithium replenishment material was lithium-rich lithium iron oxide (Li₅FeO₄). A lithium replenishment mass was 0.328 g. A theoretical gram capacity was 0.867 Ah/g. Therefore, a theoretical replenishment capacity C₅ of active ions could be calculated to be 0.284 Ah. A second battery was exactly the same as the first battery except that the second battery was not subjected to lithium replenishment. Before testing, for the battery with lithium replenishment, the copper wire was used as a negative electrode, a positive electrode of the battery with lithium replenishment was used as a positive electrode, and charging was performed for 1 h at a constant current of 10 µA. For the battery without lithium replenishment, the copper wire was used as a negative electrode, a positive electrode of the battery with lithium replenishment was used as a positive electrode, and charging was performed for 1 h at a constant current of 10 µA. This process allowed a metal lithium layer with a thickness of about 30 µm to be deposited on the surface of the copper wire.

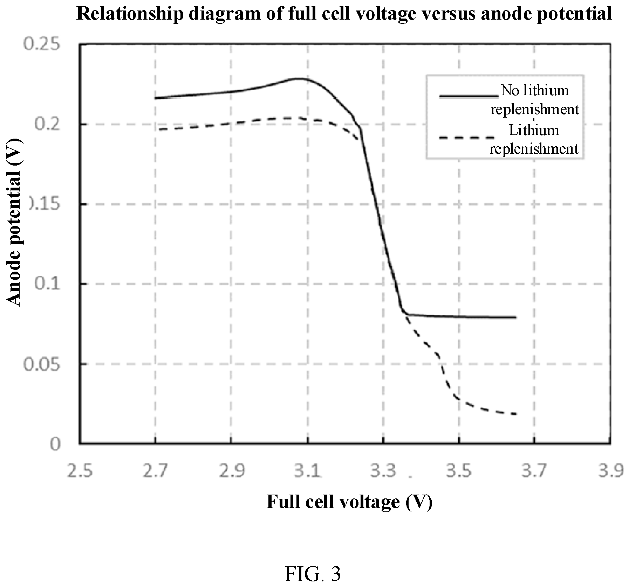

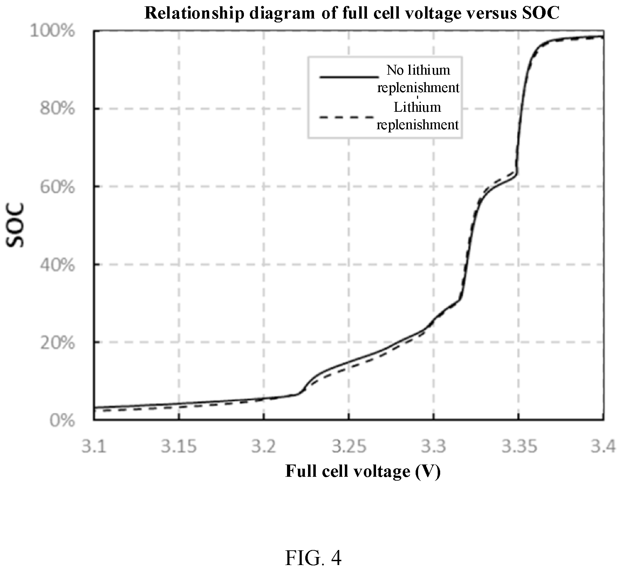

The battery with lithium replenishment and the battery without lithium replenishment were charged at a rate of 0.04C in a nominal voltage range of 2.5 V to 3.65 V to obtain anode potential-battery voltage curves and SOC-battery voltage curves of respective charging processes. FIG. 3 is a graph showing anode potential-full cell voltage curves of the battery with lithium replenishment and the battery without lithium replenishment of LFP. FIG. 4 is a graph showing SOC-full cell voltage curves of the battery with lithium replenishment and the battery without lithium replenishment of LFP.

In FIG. 3, an overlapping range U₁ of the two curves was determined to be 3.25 V to 3.35 V. In FIG. 4, a voltage range U₂ with a low slope such as 2.7 V to 3.3 V was selected. An overlapping voltage range of the determined U₁ and U₂, which was a range of 3.25 V to 3.3 V, was selected. Any voltage in this range might be used as a charge cut-off voltage. In this example, a median value of 3.275 V was selected for evaluation.

The battery with lithium replenishment and the battery without lithium replenishment were discharged at a rate of 0.04C, where the battery with lithium replenishment was discharged to a nominal lower-limit voltage, and the battery without lithium replenishment was discharged to an anode potential of 1 V. A discharge capacity C₂ of the battery with lithium replenishment was recorded as 2.11 Ah, and a discharge capacity C₄ of the battery without lithium replenishment was recorded as 1.93 Ah.

The battery with lithium replenishment and the battery without lithium replenishment were charged at a rate of 0.04C to a charge cut-off voltage of 3.275 V. According to the test data, a charge capacity of the battery with lithium replenishment when charged to 3.275 V was 0.44 Ah, and a capacity of the battery without lithium replenishment when charged to 3.275 V was 0.49 Ah, so that a capacity difference C1 was equal to 0.05 Ah. Therefore, a total effective capacity of active lithium ions in the first battery was calculated to be C₃=C₁+C₂=2.16 Ah. The lithium replenishment efficiency was calculated to be A=(C₃-C₄)/C₅=81%.

### Example 2: Evaluation of NCM secondary battery

Both a battery with lithium replenishment and a battery without lithium replenishment were full cells and were internally provided with a reference electrode copper wire. A diameter of the copper wire was 50 µm. A positive electrode material was LiNi_{0.8}Co_{0.1}Mn_{0.1}O₂ (NCM811). A positive electrode current collector was an aluminum foil. A weight ratio of NCM811, a conductive agent acetylene black, and a binder PVDF in a positive electrode film layer was 94:4:2. A negative electrode material included graphite and silicon monoxide (SiO). A negative electrode current collector was a copper foil. A weight ratio of graphite, SiO, a conductive agent acetylene black, and a binder with SBR+CMC in a negative electrode film layer was 67.5:22.5:1.5:7:1.5. A solvent was formed by ethylene carbonate (EC), propylene carbonate (PC), and dimethyl carbonate (DMC) at a weight ratio of EC:PC:DMC=3:3:3. A concentration of a lithium salt LiPF₆ in an electrolyte was 1 mol/L. A polyethylene porous film with a thickness of 12 µm was used as a separator. A first battery was subjected to lithium replenishment at a negative electrode. A lithium replenishment material was metallic lithium. A lithium replenishment mass was 0.367 g. A theoretical gram capacity was 3.86 Ah/g. Therefore, a theoretical replenishment capacity C₅ of active ions could be calculated to be 1.42 Ah. The lithium replenishment process and subsequent battery production were all carried out at 25°C with a humidity of less than 2%. A second battery was exactly the same as the first battery except that the second battery was not subjected to lithium replenishment. Before testing, for the battery with lithium replenishment, the copper wire was used as a negative electrode, a positive electrode of the battery with lithium replenishment was used as a positive electrode, and charging was performed for 1 h at a constant current of 10 µA. For the battery without lithium replenishment, the copper wire was used as a negative electrode, a positive electrode of the battery with lithium replenishment was used as a positive electrode, and charging was performed for 1 h at a constant current of 10 µA. This process allowed a metal lithium layer with a thickness of about 30 µm to be deposited on the surface of the copper wire.

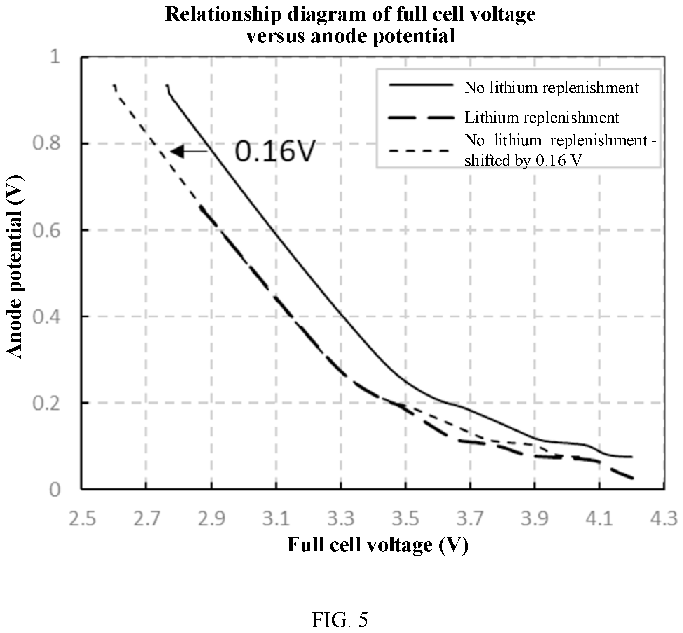

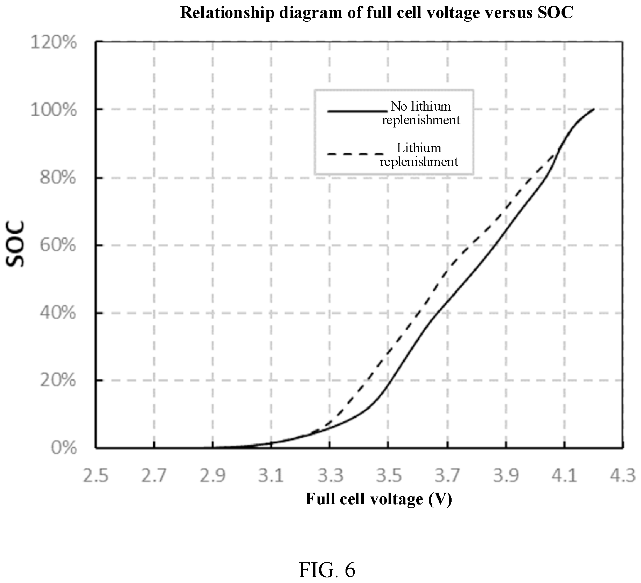

The battery with lithium replenishment and the battery without lithium replenishment were charged and discharged at a rate of 0.04C in a nominal voltage range of 2.5 V to 4.2 V to obtain respective anode potential-battery voltage curve and SOC-battery voltage curves during charging processes. FIG. 5 shows an anode potential-full cell voltage graph of the battery with lithium replenishment and the battery without lithium replenishment of NCM. FIG. 6 shows an SOC-full cell voltage graph of the battery with lithium replenishment and the battery without lithium replenishment of NCM.

In FIG. 5, the anode potential-full cell voltage curve of the battery without lithium replenishment was shifted, so that the shifted curve overlapped with the anode potential-full cell voltage curve of the battery with lithium replenishment near 3.1 V. As shown in FIG. 5, the shift amount was 0.16 V, and a full cell voltage range U₁₋₁ corresponding to an overlapping portion of the anode potential-full cell voltage curve of the battery with lithium replenishment and the shifted anode potential-full cell voltage curve of the battery without lithium replenishment was determined to be 2.9 V to 3.5 V. The full cell voltage range of the battery with lithium replenishment corresponding to the range of 2.9 V to 3.5 V needed to be added with the shift amount with respect to a full cell voltage range U₁₋₂ of the battery without lithium replenishment, which was calculated to be 3.06 V to 3.66 V.

In FIG. 6, a range with a low slope was determined. For the battery with lithium replenishment, the full cell voltage range U₂₋₁ was 2.9 V to 3.3 V, and for the battery without lithium replenishment, the full cell voltage range U₂₋₂ was 2.9 V to 3.4 V.

An overlapping range of U₁₋₁ and U₂₋₁ of the battery with lithium replenishment was determined to be 2.9 V to 3.3 V, and an overlapping range of U₂₋₁ and U₂₋₂ of the battery without lithium replenishment was determined to be 3.06 V to 3.4 V. A charge cut-off voltage of the battery with lithium replenishment was determined to be a median value 3.1 V of 2.9 V to 3.3 V, and a charge cut-off voltage of the battery without lithium replenishment was determined to be a median value 3.26 V of 3.1 V+0.16 V, so that the battery with lithium replenishment and the battery without lithium replenishment were charged to an identical anode potential.

The battery with lithium replenishment and the battery without lithium replenishment were discharged at a rate of 0.04C, where the battery with lithium replenishment was discharged to a nominal lower-limit voltage, and the battery without lithium replenishment was discharged to an anode potential of 1 V. A discharge capacity C₂ of the battery with lithium replenishment was recorded as 4.38 Ah, and a discharge capacity C₄ of the battery without lithium replenishment was recorded as 3.25 Ah.

The battery with lithium replenishment and the battery without lithium replenishment were charged at a rate of 0.04C, where a charge cut-off voltage of the battery with lithium replenishment was 3.1 V, and a charge cut-off voltage of the battery without lithium replenishment was 3.26 V. The battery with lithium replenishment and the battery without lithium replenishment were charged to an identical anode potential.

According to the test data, a charge capacity of the battery with lithium replenishment when charged to 3.1 V was 0.07 Ah. After the battery without lithium replenishment was discharged, a capacity when charged to 3.26 V was 0.16 Ah, so that a capacity difference C₁ was equal to 0.09 Ah. Therefore, a total capacity of active lithium ions in the first battery was calculated to be C₃=C₁+C₂=4.47 Ah. The lithium replenishment efficiency was calculated to be A=(C₃-C₄)/C₅=86%.

### Example 3: Evaluation of NCM secondary battery (influence of temperature)

When metallic lithium was used for lithium replenishment, lithium reacted with an anode electrode plate, the electrode plate generated heat and experienced temperature rise, the reaction of lithium with air was intensified, and the lithium replenishment efficiency was reduced, thus leading to a lower amount of active lithium in the battery than the design value and shorter battery life.

The electrode plate used in Example 3 was the same as that in Example 2. The manufacturing processes were the same except that the standing temperature after lithium replenishment was different for the battery with lithium replenishment, so as to test the influence of temperature on the lithium replenishment effect.

Specifically, the positive electrode plate and the negative electrode plate used in this example were the same as those in Example 2. The first battery was subjected to lithium replenishment. A lithium replenishment material was metallic lithium. A lithium replenishment mass was 0.37 g. A theoretical gram capacity was 3.86 Ah/g. Therefore, a theoretical replenishment capacity C₅ of active ions could be calculated to be 1.43 Ah. The lithium replenishment process was carried out at 25°C with a humidity of less than 2%. After lithium replenishment, winding was performed immediately to obtain a jelly roll (Jelly roll), and then the jelly roll was placed in a 40°C thermostat for 6 h (in an atmospheric environment with a humidity of less than 2%) to simulate the influence of heat generation in the electrode plate. After standing, subsequent production steps were carried out at room temperature, where the process conditions were the same as those in Example 2.

The test process and the data analysis method were the same as those in Example 2. A discharge capacity C₂ of the first battery was obtained as 4.38 Ah, a discharge capacity C₄ of the battery without lithium replenishment was 3.25 Ah, and a charge capacity difference C₁ of the battery without lithium replenishment and the battery with lithium replenishment was equal to 0.03 Ah. Therefore, a total capacity of active lithium ions in the first battery was calculated to be C₃=C₁+C₂=4.41 Ah. The lithium replenishment efficiency was calculated to be A=(C₃-C₄)/C₅=81%.

From comparison of the results of Example 2, it can be seen that temperature has significant negative influence on the lithium replenishment efficiency, resulting in the decreased capacity of active lithium ions in the battery and lower lithium replenishment efficiency, thus affecting the effect of extending the battery life. Therefore, controlling the temperature of the electrode plate or the jelly roll during and after lithium replenishment helps to reduce the side reactions between lithium and air, allowing the metallic lithium replenishment effect to be fully exerted, thereby achieving high lithium replenishment efficiency.

From further analysis of the data in Examples 2 and 3, it can also be seen that under different lithium replenishment efficiencies, the discharge capacity C₂ of the battery with lithium replenishment shows no significant difference. This is because the lithium replenishment amount of the battery is high. Under lithium replenishment efficiencies of 86% and 81%, the replenished active lithium is sufficient to compensate for the irreversible active lithium consumption of the negative electrode (mainly from SEI film formation). At this point, the capacity of the battery is determined by the reversible capacity of the positive electrode. Since the same electrode plates are used in the two examples, the positive electrode capacities are the same, so the measured C₂ shows no difference. The above test results also show that testing the total capacity of active lithium ions or the lithium replenishment efficiency of the battery with lithium replenishment can effectively identify the lithium replenishment effect, for example, identifying whether the above lithium replenishment temperature is abnormal. If only the discharge capacity C₂ is analyzed, it is difficult to ensure that a lithium replenishment evaluation result with reference value is obtained.

Although this application has been described with reference to the preferred embodiments, various modifications to this application and replacements of the components therein with equivalents can be made without departing from the scope of this application. In particular, as long as there is no structural conflict, the technical features mentioned in the embodiments can be combined in any manner. This application is not limited to the specific embodiments disclosed herein, but includes all technical solutions falling within the scope of the claims.

## Claims

1. An evaluation method for an effective replenishment level of active ions in a secondary ion battery, wherein the secondary ion battery is a first battery, and a secondary ion battery without active ion replenishment corresponding to the secondary ion battery is a second battery; and the evaluation method comprises:
acquiring a discharge capacity C₂ of the first battery during discharging in a nominal voltage range;
charging the first battery and the second battery to respective preset voltages U, and when an anode potential of the first battery is equal to an anode potential of the second battery at the preset voltages U, calculating a charge capacity difference C₁ of the first battery and the second battery at this point; and
calculating a sum C₃ of the charge capacity difference C₁ and the discharge capacity C₂, wherein C₃ is used to characterize a total effective capacity of active ions in the first battery.

2. The evaluation method according to claim 1, wherein the evaluation method comprises:
acquiring curves, comprising: acquiring a first curve and a second curve of the first battery and the second battery during a charging process or a discharging process in the nominal voltage range, and the discharge capacity C₂ of the first battery, wherein both the first curve and the second curve are full charging process curves or full discharging process curves, the first curve is an anode potential-battery voltage curve of the first battery, and the second curve is an anode potential-battery voltage curve of the second battery;
acquiring a voltage range U₁, comprising: determining a battery voltage range U₁₋₁ of the first battery and a battery voltage range U₂₋₁ of the second battery corresponding to portions having identical curve shapes in an identical anode potential range in the first curve and the second curve;
acquiring a capacity difference C₁, comprising: acquiring charge capacities of the first battery and the second battery when the first battery and the second battery are charged to the respective preset voltages U, wherein the preset voltage U of the first battery is any value in U₁₋₁, and the preset voltage U of the second battery is any value in U₂₋₁; and calculating the charge capacity difference C₁ of the first battery and the second battery at this point; and
acquiring a total effective capacity of active ions, comprising: calculating a sum C₃ of the charge capacity difference C₁ and the discharge capacity C₂.

3. The evaluation method according to claim 2, wherein the process of acquiring the capacity difference C₁ comprises:
discharging the first battery and the second battery respectively and then charging the first battery and the second battery to the respective preset voltages U, and calculating the charge capacity difference C₁ of the first battery and the second battery at this point, wherein the first battery is discharged to a nominal lower-limit voltage, and the second battery is discharged to an anode potential of 1 V to 2.5 V or discharged until the anode potential reaches an SEI film decomposition potential.

4. The evaluation method according to claim 3, wherein a discharge rate is any rate selected from 0.02C to 0.1C.

5. The evaluation method according to claim 3, wherein the first battery and the second battery are charged respectively to the preset voltages U at any rate ranging from 0.02C to 0.1C.

6. The evaluation method according to any one of claims 2 to 5, wherein the preset voltage U of the first battery is a median voltage value of U₁₋₁, and the preset voltage U of the second battery is a median voltage value of U₂₋₁.

7. The evaluation method according to any one of claims 2 to 5, wherein the process of determining U₁₋₁ and U₂₋₁ comprises:
shifting a voltage value t₁ of the first curve and/or shifting a voltage value t₂ of the second curve along a coordinate line where a battery voltage is located, so that the first curve and the second curve overlap in a battery voltage range U', wherein t₁ and t₂ are negative values when the shift is performed in a direction toward a lower battery voltage, t₁ and t₂ are positive values when the shift is performed in a direction toward a higher battery voltage, and t₁ and t₂ satisfy any one or more of the following conditions: 0 V≤|t₁|≤2.0 V, 0 V≤|t₂|≤2.0 V, and 0 V≤|t₁|+|t₂|≤2.0 V; and
calculating U₁₋₁ and U₂₋₁ according to the following formulas: U₁₋₁=U'-t₁, and U₂₋₁=U'-t₂.

8. The evaluation method according to any one of claims 2 to 5, wherein the process of acquiring the curves further comprises a process of acquiring a third curve and a fourth curve during a charging process or a discharging process in the nominal voltage range, wherein both the third curve and the fourth curve are full charging process curves or full discharging process curves, the third curve is an SOC-battery voltage curve of the first battery, and the fourth curve is an SOC-battery voltage curve of the second battery; and
the evaluation method further comprises: determining a first battery voltage range U₁₋₂ corresponding to a curve segment in the third curve where a slope does not exceed 400% SOC/battery voltage, and determining a second battery voltage range U₂₋₂ corresponding to a curve segment in the fourth curve where a slope does not exceed 400% SOC/battery voltage;
determining a voltage range U₁ where U₁₋₁ and U₁₋₂ overlap; and
determining a voltage range U₂ where U₂₋₁ and U₂₋₂ overlap; wherein in the process of acquiring the charge capacity difference C1, the preset voltage U of the first battery is any value in U₁, and the preset voltage U of the second battery is any value in U₂.

9. The evaluation method according to claim 8, wherein the preset voltage U of the first battery is a median voltage value of U₁, and the preset voltage U of the second battery is a median voltage value of U₂.

10. The evaluation method according to any one of claims 2 to 5, wherein the process of acquiring the curves comprises:
performing charging treatment or discharging treatment on the first battery and the second battery respectively at an identical rate in the nominal voltage range to acquire the first curve and the second curve.

11. The evaluation method according to claim 10, wherein a rate of the charging process or the discharging process is any rate selected from 0.02C to 0.1C.

12. The evaluation method according to any one of claims 2 to 5, wherein the evaluation method further comprises a step of recording a discharge capacity C₄ of the second battery; and
the evaluation method further comprises a process of calculating active ion replenishment efficiency, wherein the active ion replenishment efficiency is denoted as A=(C₃-C₄)/C₅, and C₅ is a theoretical active ion replenishment capacity.

13. The evaluation method according to any one of claims 1 to 5, wherein the first battery and the second battery are each provided with a reference electrode, and the reference electrodes are used to monitor anode potentials of the first battery and the second battery during charging and discharging processes.

14. The evaluation method according to claim 13, wherein the reference electrode is a conductive wire with an active material layer on a surface, a diameter of the conductive wire is 50 µm to 100 µm, and a thickness of the active material layer is 10 µm to 50 µm.

15. The evaluation method according to claim 14, wherein the reference electrode is a copper wire, a copper wire with a lithium-plated layer on a surface, a copper wire with a sodium-plated layer on a surface, a copper wire coated with a lithium iron phosphate layer on a surface, a copper wire coated with a lithium titanate layer on a surface, or a copper wire coated with a sodium vanadium phosphate layer on a surface;
when the reference electrode is a copper wire, before evaluation is performed, a positive electrode of the first battery is used as a positive electrode, the copper wire is used as a negative electrode, and charging is performed for 1 h at a constant current of 10 µA to perform electroplating treatment on the copper wire of the first battery; and a positive electrode of the second battery is used as a positive electrode, the copper wire is used as a negative electrode, and charging is performed for 1 h at a constant current of 10 µA to perform electroplating treatment on the copper wire of the second battery; and
when the reference electrode is a copper wire coated with a lithium iron phosphate layer on a surface, a copper wire coated with a lithium titanate layer on a surface, or a copper wire coated with a sodium vanadium phosphate layer on a surface, the evaluation method further comprises a process of first activating the reference electrode, wherein the process of activating the reference electrode comprises:
charging the first battery and the second battery respectively to a battery voltage corresponding to 50±5% SOC.

16. The evaluation method according to any one of claims 1 to 5, wherein both the first battery and the second battery are full cells, and the secondary ion battery is a lithium-ion secondary battery or a sodium-ion secondary battery.

17. The evaluation method according to claim 1, wherein the evaluation method comprises:
providing a reference electrode in each of the first battery and the second battery, and using the reference electrodes to monitor anode potentials of the first battery and the second battery during charging and discharging processes, wherein both the first battery and the second battery are full cells, the reference electrode is a copper wire, a copper wire with lithium plated on a surface, a copper wire with sodium plated on a surface, a copper wire coated with lithium iron phosphate on a surface, a copper wire coated with lithium titanate on a surface, or a copper wire coated with sodium vanadium phosphate on a surface, a diameter of the copper wire is 50 µm to 100 µm, and a thickness of an active material layer on the copper wire is 10 µm to 50 µm; when the reference electrode is a copper wire, before performing evaluation, using a positive electrode of the first battery as a positive electrode and the copper wire as a negative electrode to perform charging for 1 h at a constant current of 10 µA so as to perform electroplating treatment on the copper wire of the first battery, and using a positive electrode of the second battery as a positive electrode and the copper wire as a negative electrode to perform charging for 1 h at a constant current of 10 µA so as to perform electroplating treatment on the copper wire of the second battery; and when the reference electrode is a copper wire coated with lithium iron phosphate on a surface, a copper wire coated with lithium titanate on a surface, or a copper wire coated with sodium vanadium phosphate on a surface, charging the first battery and the second battery respectively to a battery voltage corresponding to 50±5% SOC so as to activate the reference electrode;
charging the first battery and the second battery in a nominal voltage range at any rate ranging from 0.02C to 0.1C, acquiring an anode potential-battery voltage curve and an SOC-battery voltage curve of the first battery, and an anode potential-battery voltage curve and an SOC-battery voltage curve of the second battery, defining the anode potential-battery voltage curve of the first battery as a first curve, defining the anode potential-battery voltage curve of the second battery as a second curve, defining the SOC-battery voltage curve of the first battery as a third curve, and defining the SOC-battery voltage curve of the second battery as a fourth curve;
determining a battery voltage range U₁₋₁ of the first battery and a battery voltage range U₂₋₁ of the second battery corresponding to portions having identical curve shapes in an identical anode potential range in the first curve and the second curve, wherein the process of determining U₁₋₁ and U₂₋₁ comprises: shifting a voltage value t₁ of the first curve and/or shifting a voltage value t₂ of the second curve along a coordinate line where a battery voltage is located, so that the first curve and the second curve overlap in a battery voltage range U', wherein t₁ and t₂ are negative values when the shift is performed in a direction toward a lower battery voltage, t₁ and t₂ are positive values when the shift is performed in a direction toward a higher battery voltage, and t₁ and t₂ satisfy any one or more of the following conditions: 0 V≤|t₁|≤2.0 V, 0 V≤|t₂|≤2.0 V, and 0 V≤|t₁|+|t₂|≤2.0 V; and calculating U₁₋₁ and U₂₋₁ according to the following formulas: U₁₋₁=U'-t₁, and U₂₋₁=U'-t₂;
determining a first battery voltage range U₁₋₂ corresponding to a curve segment in the third curve where a slope does not exceed 400% SOC/battery voltage, and determining a second battery voltage range U₂₋₂ corresponding to a curve segment in the fourth curve where a slope does not exceed 400% SOC/battery voltage;
determining a voltage range U₁ where U₁₋₁ and U₁₋₂ overlap, and determining a voltage range U₂ where U₂₋₁ and U₂₋₂ overlap;
discharging the first battery and the second battery, wherein a discharge rate is any rate selected from 0.02C to 0.1C, the first battery is discharged to a nominal lower-limit voltage, and the second battery is discharged to an anode potential of 1 V to 2.5 V or discharged until the anode potential reaches an SEI film decomposition potential; recording a discharge capacity C₂ of the first battery and a discharge capacity C₄ of the second battery; acquiring charge capacities of the first battery and the second battery when the first battery and the second battery are charged respectively to the preset voltages U at any rate ranging from 0.02C to 0.1C, wherein the preset voltage U of the first battery is a median voltage value of U₁, and the preset voltage U of the second battery is a median voltage value of U₂; and calculating a charge capacity difference C₁ of the first battery and the second battery at this point;
calculating a total effective capacity C₃ of active ions in the first battery using formula (I), wherein formula (I) is as follows: C₃=C₁+C₂; and
calculating active ion replenishment efficiency using formula (II), wherein formula (II) is as follows: A=(C₃-C₄)/C₅, wherein C₅ is a theoretical active ion replenishment capacity, C₅=m×k, m is a mass of an additionally provided active ion material, and k is a gram capacity; wherein when the additionally provided active ion material is lithium metal, k is 3.86 Ah/g; and when the additionally provided active ion material is sodium metal, k is 1.165 Ah/g.

18. The evaluation method according to claim 1, wherein the evaluation method comprises:
providing a reference electrode in each of the first battery and the second battery, and using the reference electrode to monitor anode potentials of the first battery and the second battery during charging and discharging processes, wherein both the first battery and the second battery are full cells, the reference electrode is a copper wire, a copper wire with lithium plated on a surface, a copper wire with sodium plated on a surface, a copper wire coated with lithium iron phosphate on a surface, a copper wire coated with lithium titanate on a surface, or a copper wire coated with sodium vanadium phosphate on a surface, a diameter of the copper wire is 50 µm to 100 µm, and a thickness of an active material layer on the copper wire is 10 µm to 50 µm; when the reference electrode is a copper wire, before performing evaluation, using a positive electrode of the first battery as a positive electrode and the copper wire as a negative electrode to perform charging for 1 h at a constant current of 10 µA so as to perform electroplating treatment on the copper wire of the first battery, and using a positive electrode of the second battery as a positive electrode and the copper wire as a negative electrode to perform charging for 1 h at a constant current of 10 µA so as to perform electroplating treatment on the copper wire of the second battery; and when the reference electrode is a copper wire coated with lithium iron phosphate on a surface, a copper wire coated with lithium titanate on a surface, or a copper wire coated with sodium vanadium phosphate on a surface, charging the first battery and the second battery respectively to a battery voltage corresponding to 50±5% SOC so as to activate the reference electrode;
charging and discharging the first battery and the second battery in a nominal voltage range at any rate ranging from 0.02C to 0.1C, acquiring an anode potential-battery voltage curve and an SOC-battery voltage curve of the first battery, and an anode potential-battery voltage curve and an SOC-battery voltage curve of the second battery during discharging, recording a discharge capacity C₄ of the second battery, defining the anode potential-battery voltage curve of the first battery as a first curve, defining the anode potential-battery voltage curve of the second battery as a second curve, defining the SOC-battery voltage curve of the first battery as a third curve, and defining the SOC-battery voltage curve of the second battery as a fourth curve;
determining a battery voltage range U₁₋₁ of the first battery and a battery voltage range U₂₋₁ of the second battery corresponding to portions having identical curve shapes in an identical anode potential range in the first curve and the second curve, wherein the process of determining U₁₋₁ and U₂₋₁ comprises: shifting a voltage value t₁ of the first curve and/or shifting a voltage value t₂ of the second curve along a coordinate line where a battery voltage is located, so that the first curve and the second curve overlap in a battery voltage range U', wherein t₁ and t₂ are negative values when the shift is performed in a direction toward a lower battery voltage, t₁ and t₂ are positive values when the shift is performed in a direction toward a higher battery voltage, and t₁ and t₂ satisfy any one or more of the following conditions: 0 V≤|t₁|≤2.0 V, 0 V≤|t₂|≤2.0 V, and 0 V≤|t₁|+|t₂|≤2.0 V; and calculating U₁₋₁ and U₂₋₁ according to the following formulas: U₁₋₁=U'-t₁, and U₂₋₁=U'-t₂;
determining a first battery voltage range U₁₋₂ corresponding to a curve segment in the third curve where a slope does not exceed 400% SOC/battery voltage, and determining a second battery voltage range U₂₋₂ corresponding to a curve segment in the fourth curve where a slope does not exceed 400% SOC/battery voltage;
determining a voltage range U₁ where the U₁₋₁ and the U₁₋₂ overlap, and determining a voltage range U₂ where the U₂₋₁ and the U₂₋₂ overlap;
acquiring a discharge capacity C₂ when the first battery is discharged to a nominal lower-limit voltage at any rate ranging from 0.02C to 0.1C, and acquiring a discharge capacity C₄ when the second battery is discharged to an anode potential of 1 V to 2.5 V or discharged until the anode potential reaches an SEI film decomposition potential at any rate ranging from 0.02C to 0.1C; acquiring charge capacities of the first battery and the second battery when the first battery and the second battery are charged respectively to the preset voltages U at any rate ranging from 0.02C to 0.1C, wherein the preset voltage U of the first battery is a median voltage value of U₁, and the preset voltage U of the second battery is a median voltage value of U₂; and calculating a charge capacity difference C₁ of the first battery and the second battery at this point;
calculating a total effective capacity C₃ of active ions in the first battery using formula (I), wherein formula (I) is as follows: C₃=C₁+C₂; and
calculating active ion replenishment efficiency A using formula (II), wherein formula (II) is as follows: A=(C₃-C₄)/C₅, wherein C₅ is a theoretical active ion replenishment capacity, C₅=m×k, m is a mass of an additionally provided active ion material, and k is a gram capacity; wherein when the additionally provided active ion material is lithium metal, k is 3.86 Ah/g; and when the additionally provided active ion material is sodium metal, k is 1.165 Ah/g.
